# EUROPEAN PATENT APPLICATION

(11) **EP 2 040 309 A2**
(43) Date of publication of application: **25.03.2009**
(21) Application number: 08013466.1
(22) Date of filing: 25.07.2008
(51) Int. Cl.: H01L 31/18, H01L 31/068

(54) **Thin inverted metamorphic multijunction solar cells with rigid support**

(30) Priority: 24.09.2007 US 860142
(71) Applicant: Emcore Solar Power, Inc., Albuquerque NM 87123 (US)
(72) Inventor: Varghese, Tansen, Albuquerque, New Mexico 87111 (US); Cornfeld, Arthur, Albuquerque, New Mexico 87047 (US); Diaz, Jaqueline, Albuquerque, New Mexico 87114 (US)
(74) Representative: Wagner, Karl H.

(57) **Abstract**

A multijunction solar cell including a first solar subcell having a first band gap; a second solar subcell disposed over the first subcell and having a second band gap smaller than the first band gap; a grading interlayer disposed over the second subcell and having a third band gap greater than the second band gap; a third solar subcell disposed over the interlayer that is lattice mis-matched with respect to the middle subcell and having a fourth band gap smaller than the second band gap; and either a thin (approximately 2 - 6 mil) substrate and/or a rigid coverglass supporting the first, second, and third solar subcells.

## Description

### BACKGROUND OF THE INVENTION

### 1. Field of the Invention

The present invention relates to the field of solar cell semiconductor devices, and particularly to integrated semiconductor structures mounted on a rigid carrier, such as inverted metamorphic solar cells.

### 2. Description of the Related Art

Photovoltaic cells, also called solar cells, are one of the most important new energy sources that have become available in the past several years. Considerable effort has gone into solar cell development. As a result, solar cells are currently being used in a number of commercial and consumer-oriented applications. While significant progress has been made in this area, the requirement for solar cells to meet the needs of more sophisticated applications has not kept pace with demand. Applications such as satellites used in data communications have dramatically increased the demand for solar cells with improved power and energy conversion characteristics.

In satellite and other space related applications, the size, mass and cost of a satellite power system are dependent on the power and energy conversion efficiency of the solar cells used. Putting it another way, the size of the payload and the availability of on-board services are proportional to the amount of power provided. Thus, as the payloads become more sophisticated solar cells, which act as the power conversion devices for the on-board power systems, become increasingly more important

Solar cells are often fabricated in vertical, multijunction structures, and disposed in horizontal arrays, with the individual solar cells connected together in a series. The shape and structure of an array, as well as the number of cells it contains, are determined in part by the desired output voltage and current.

Occasionally, there is a need to reduce the thickness of wafers and devices. For example, in photodiodes, reducing the thickness of the substrate reduces the heat-conducting path, and enables the photodiode to handle more light at high speed. In space photovoltaics, the advantage to reducing the thickness is reduction of the payload weight at launch.

Thinning the substrate means that some other means of support has to be given to the device layers, during processing, and in use. Also, any residual strain (from growth, thermal mismatch, etc.) in the device layers will present itself as curvature in the layers, which can be corrected by incorporating strain of the opposite sign in the support that's given to the layers, while still keeping if flexible for conformal attachment to a curved surface.

Inverted metamorphic solar cell structures such as described in U.S. Patent No. 6,951,819 and M.W. Wanlass et al., Lattice Mismatched Approaches for High Performance, III - V Photovoltaic Energy Converters (Conference Proceedings of the 31st IEEE Photovoltaic Specialists Conference, Jan. 3-7, 2005, IEEE Press, 2005) are important new solar cell structures and present one approach to thinning the substrate in a solar cell. However, the structures described in such prior art present a number of practical difficulties relating to the appropriate choice of materials and fabrication steps.

Prior to the present invention, the materials and fabrication steps disclosed in the prior art have not been adequate to produce a commercially viable, manufacturable, and energy efficient solar cell.

### SUMMARY OF THE INVENTION

### 1. Objects of the Invention

It is an object of the present invention to provide an improved multijunction solar cell.

It is an object of the invention to provide an improved inverted metamorphic solar cell.

It is still another object of the invention to provide a method of manufacturing an inverted metamorphic solar cell as a thin film mounted on a thin substrate about 2 to 6 mils in thickness.

It is still another object of the invention to provide a method of manufacturing an inverted metamorphic solar cell as a thin film mounted on a coverglass.

It is still another object of the invention to provide an inverted metamorphic solar cell as a thin film mounted on a thin substrate about 2-6 mils in thickness.

It is still another object of the invention to provide an inverted metamorphic solar cell as a thin film mounted solely on a coverglass.

Additional objects, advantages, and novel features of the present invention will become apparent to those skilled in the art from this disclosure, including the following detailed description as well as by practice of the invention. While the invention is described below with reference to preferred embodiments, it should be understood that the invention is not limited thereto. Those of ordinary skill in the art having access to the teachings herein will recognize additional applications, modifications and embodiments in other fields, which are within the scope of the invention as disclosed and claimed herein and with respect to which the invention could be of utility.

### 2. Features of the Invention

Briefly, and in general terms, the present invention provides a method of manufacturing a solar cell by providing a first substrate; depositing on the first substrate a sequence of layers of semiconductor material forming a solar cell; mounting a surrogate substrate on top of the sequence of layers; removing the first substrate; and thinning the surrogate substrate to a predetermined thickness.

. In another aspect, the present invention provides a method of manufacturing a solar cell by providing a first substrate; depositing on the first substrate a sequence of layers of semiconductor material forming a solar cell; mounting a surrogate substrate on top of the sequence of layers; removing the first substrate; mounting the solar cell on a rigid coverglass; and removing the surrogate substrate.

In another aspect, the present invention provides a multijunction solar cell including a first solar subcell having a first band gap; a second solar subcell disposed over the first subcell and having a second band gap smaller than the first band gap; a grading interlayer disposed over the second subcell and having a third band gap greater than the second band gap; a third solar subcell disposed over the interlayer that is lattice mis-matched with respect to the middle subcell and having a fourth band gap smaller than the second band gap; and a rigid coverglass supporting the first, second, and third solar subcells.

In another aspect, the present invention provides a solar cell arrangement comprising:
(i) a first solar cell including: a first solar subcell having a first band gap; a second solar subcell disposed over said first subcell and having a second band gap smaller than said first band gap; a grading interlayer disposed over said second subcell and having a third band gap greater than said second band gap; a third solar subcell disposed over said interlayer that is lattice-mis-matched with respect to said middle subcell and having a fourth band gap smaller than said second band gap; a metal contact layer disposed over said third solar subcell; and
(ii) a second solar cell including: a first solar subcell having a first band gap; a second solar subcell disposed over said first subcell and having a second band gap smaller than said first band gap; a grading interlayer disposed over said second subcell and having a third band gap greater than said second band gap; a third solar subcell disposed over said interlayer that is lattice-mis-matched with respect to said middle subcell and having a fourth band gap smaller than said second band gap; a metal contact layer disposed over said third solar subcell; and
(iii) a conductor bonded to said metal contact layer of said first solar cell for making electrical contact between said first solar cell and the first solar subcell of said second solar cell.

### BRIEF DESCRIPTION OF THE DRAWINGS

These and other features and advantages of this invention will be better and more fully appreciated by reference to the following detailed description when considered in conjunction with the accompanying drawings, wherein:

FIG. 1 is an enlarged cross-sectional view of the solar cell according to the present invention at the end of the process steps of forming the layers of the solar cell;

FIG. 2 is a cross-sectional view of the solar cell of FIG. 1 after the next process step according to the present invention in which backside contact metallization is applied;

FIG. 3 is a cross-sectional view of the solar cell of FIG. 2 after the next process step according to the present invention in which an adhesive is applied;

FIG. 4 is a cross-sectional view of the solar cell of FIG. 3 after the next process step according to the present invention in which a surrogate substrate is attached;

FIG. 5A is a cross-sectional view of the solar cell of FIG. 4 after the next process step according to the present invention in which the original substrate is removed;

FIG. 5B is a cross-sectional view of the solar cell of FIG. 5A with the surrogate substrate depicted at the bottom of the Figure;

FIG. 6A is a top plan view of a wafer in which the solar cells according to the present invention are fabricated;

FIG. 6B is a bottom plan view of a wafer in which the solar cells according to the present invention are fabricated;

FIG. 7 is a top plan view of the wafer of FIG. 6B after the next process step according to the present invention;

FIG. 8 is a cross-sectional view of the solar cell of FIG. 5B after the next process step according to the present invention in which the buffer layer has been etched off;

FIG. 9 is a cross-sectional view of the solar cell of FIG. 8 after the next process step according to the present invention;

FIG. 10 is a cross-sectional view of the solar cell of FIG. 9 after the next process step according to the present invention;

FIG. 11 is a cross-sectional view of the solar cell of FIG. 10 after the next process step according to the present invention;

FIG. 12 is a cross-sectional view of the solar cell of FIG. 11 after the next process step according to the present invention in which an ARC layer has been deposited;

FIG. 13 is a cross-sectional view of the solar cell of FIG. 12 after the next process step according to a first embodiment of the present invention in which a mesa etch isolation has been performed;

FIG. 14A is a cross-sectional view of the solar cell of FIG. 13 after the next process step according to a first embodiment of the present invention in which the surrogate substrate has been thinned to a desired thickness;

FIG. 14B is a cross-sectional view of the solar cell of FIG. 14A after the next process step according to a second embodiment of the present invention in which a coverglass is adhered to the solar cell;

FIG. 15 is a cross-sectional view of a portion of a solar cell array which depicts the solar cell of FIG. 14A after the next process step according to an aspect of the present invention in which an electrical connection is made from a first cell to an adjacent solar cell;

FIG. 16A is a cross-sectional view of the solar cell of FIG. 13 in a third embodiment of the present invention after the next process step of adhering a coverglass to the structure; and

FIG. 16B is a cross-sectional view of the solar cell of FIG. 16A after the next process step of removing the substrate.

### DESCRIPTION OF THE PREFERRED EMBODIMENT

Details of the present invention will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale.

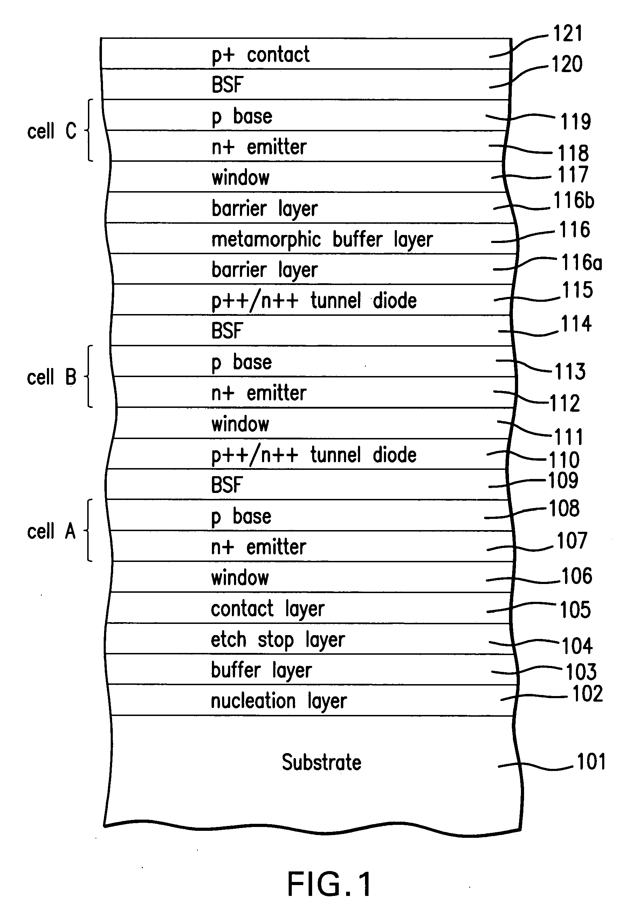

FIG. 1 depicts the multijunction solar cell according to the present invention after formation of the three subcells A, B and C on a substrate. More particularly, there is shown a substrate 101, which may be either gallium arsenide (GaAs), germanium (Ge), or other suitable material. In the case of a Ge substrate, a suitable nucleation layer 102 is deposited on the substrate. On the substrate, or over the nucleation layer 102, a buffer layer 103, and an etch stop layer 104 are further deposited. A contact layer 105 is then deposited on layer 104, and a window layer 106 is deposited on the contact layer. The subcell A, consisting of an n+ emitter layer 107 and a p-type base layer 108, is then deposited on the window layer 106.

It should be noted that the multijunction solar cell structure could be formed by any suitable combination of group III to V elements listed in the periodic table subject to lattice constant and band gap requirements, wherein the group III includes boron (B), aluminum (Al), gallium (Ga), indium (In), and thallium (T). The group IV includes carbon (C), silicon (Si), germanium (Ge), and tin (Sn). The group V includes nitrogen (N), phosphorous (P), arsenic (As), antimony (Sb), and bismuth (Bi).

In the preferred embodiment, the n+ emitter layer 107 is composed of InGa(Al)P And p-type the base layer 108 is composed of InGA(Al)P. The Al term is parenthesis in the preceding formula means that A1 is an optional constituent, and in this instance may be used in an amount ranging from 0% to 30%.

On top of the base layer 108 is deposited a back surface field ("BSF") layer 109 used to reduce recombination loss.

The BSF layer 109 drives minority carriers from the region near the base/BSF interface surface to minimize the effect of recombination loss. In other words, a BSF layer 109 reduces recombination loss at the backside of the solar subcell A and thereby reduces the recombination in the base.

On top of the BSF layer 109 is deposited a sequence of heavily doped p-type and n-type layers 110 which forms a tunnel diode which is a circuit element to connect subcell A to subcell B.

On top of the tunnel diode layers 110 a window layer 111 is deposited. The window layer 111 used in the subcell B also operates to reduce the recombination loss. The window layer 111 also improves the passivation of the cell surface of the underlying junctions.
It should be apparent to one skilled in the art, that additional layer(s) may be added or deleted in the cell structure without departing from the scope of the present invention.

On top of the window layer 111 the layers of cell B are deposited: the emitter layer 112, and the p-type base layer 113. These layers are preferably composed of InGaP and In_{0.015}GaAs respectively, although any other suitable materials consistent with lattice constant and band gap requirements may be used as well.

On top of the cell B is deposited a BSF layer 114 which performs the same function as the BSF layer 109. A p++/n++ tunnel diode 115 is deposited over the BSF layer 114 4 similar to the layers 110, again forming a circuit element to connect cell B to cell C.

A barrier layer 116a, preferably composed of InGa(Al)P, is deposited over the tunnel diode 115, to a thickness of about 1.0 micron. Such barrier layer is intended to prevent threading dislocations from propagating, either opposite to the direction of growth into the middle and top subcells B and C, or in the direction of growth into the bottom subcell A.

A metamorphic layer 116 is deposited over the barrier layer 116a. Layer 116 is preferably a compositionally step-graded series of InGaAlAs layers with monotonically changing lattice constant that is intended to achieve a transition in lattice constant from subcell B to subcell C. The band gap of layer 116 is 1.5 eV consistent with a value slightly greater than the band gap of the middle subcell B.

In one embodiment, as suggested in the Wanless et al. paper, the step grade contains nine compositionally graded InGaP steps with each step layer having a thickness of 0.25 micron. In the preferred embodiment, the layer 116 is composed of nine layers of InGaAlAs, with monotonically changing lattice constant, or more particularly InₓGa₁₋ₓ AlAs with x chosen so that the band gap is constant at 1.50 eV. The number of layers, and the composition and lattice constant of each layer, may be appropriately adjusted depending on other growth or structural requirements.

In another embodiment of the present invention, an optional second barrier layer 116b may be deposited over the InGaAlAs metamorphic layer 116. The second barrier layer 116b will typically have a slightly different composition than that of barrier layer 116a.

A window layer 117 is deposited over the barrier layer 116b, this window layer operating to reduce the recombination loss in subcell "C". It should be apparent to one skilled in the art that additional layers may be added or deleted in the cell structure without departing from the scope of the present invention.

On top of the window layer 117, the layers of cell C are deposited: the n+ emitter layer 118, and the p-type base layer 119. These layers are preferably composed of InGaP and GaInAs respectively, although another suitable materials consistent with lattice constant and band gap requirements may be used as well.

A BSF layer 120 is deposited on top of the cell C, the BSF layer performing the same function as the BSF layers 109 and 114.

Finally a p+ contact layer 121 is deposited on the BSF layer 120.

It should be apparent to one skilled in the art, that additional layer(s) may be added or deleted in the cell structure without departing from the scope of the present invention.

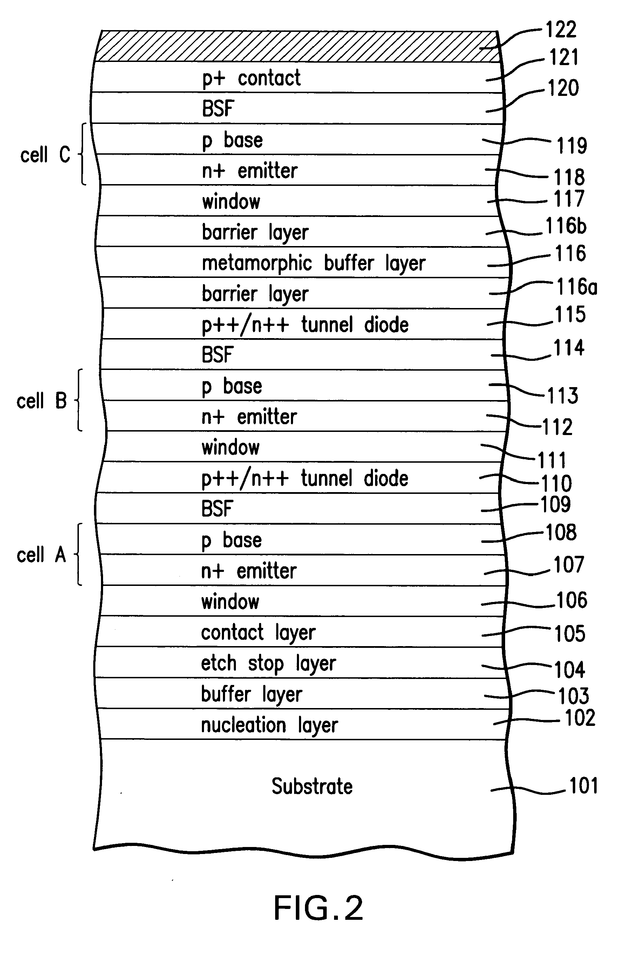

FIG. 2 is a cross-sectional view of the solar cell of FIG. 1 after the next process step in which a metal contact layer 122 is deposited over the p+ semiconductor contact layer 121. The metal is preferably the sequence of layers Ti/Au/Ag/Au.

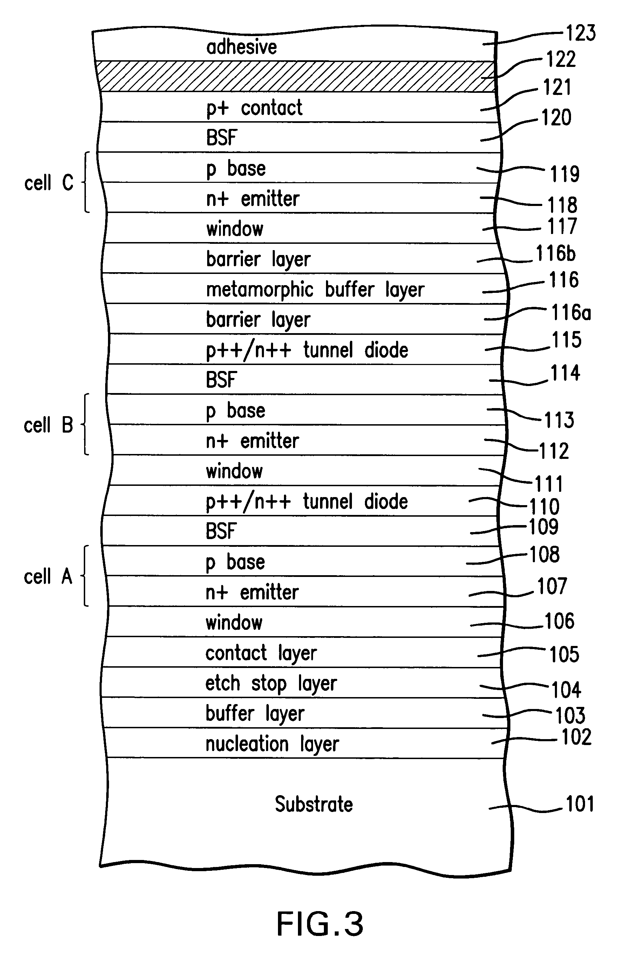

FIG. 3 is a cross-sectional view of the solar cell of FIG. 2, after the next process step, in which an adhesive 123 is applied over the metal layer 122. The adhesive can be a temporary adhesive, or a permanent one. The permanent bond can even be due to the metal layer itself, for example in the case of eutectic or thermo compression bonding, to the substrate to be attached.

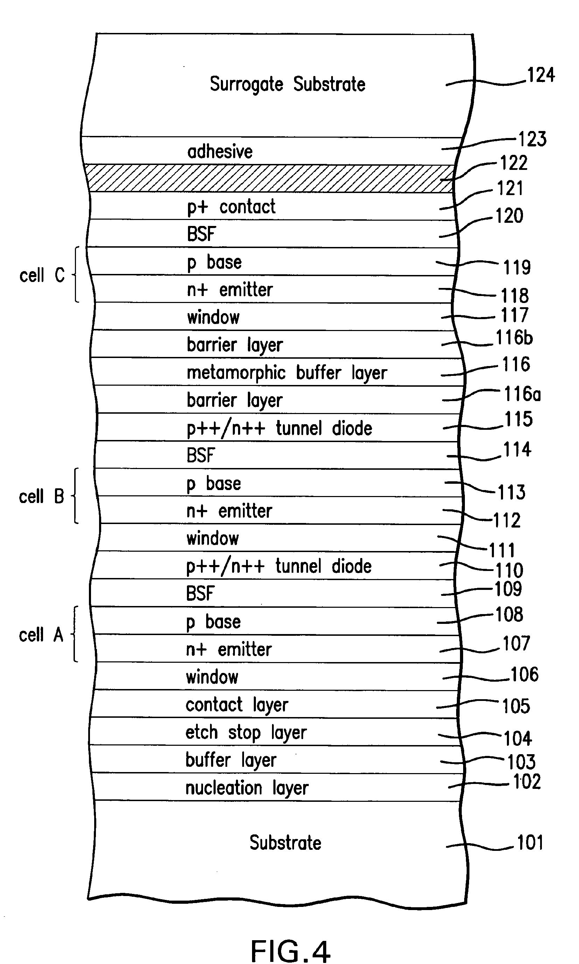

FIG. 4 is a cross-sectional view of the solar cell of FIG. 3, after the next process step, in which a surrogate substrate is attached, using the adhesion method detailed above. This surrogate substrate can be a temporary substrate, such as sapphire or glass, up to 1 mm in thickness. Or it can be a permanent substrate such as a silicon or germanium wafer, which can be electrically and/or thermally conductive. Using germanium as the substrate also allows thermal expansion matching between the III - V semiconductor layers of the solar cell and the substrate, thereby reducing warpage and cracking of the substrate/device layers.

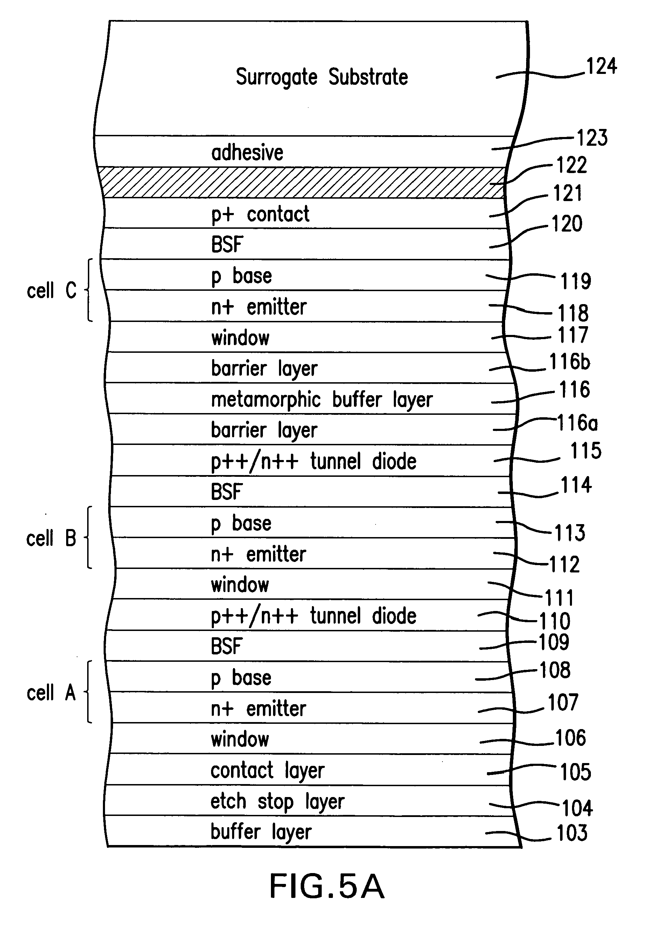

FIG. 5A is a cross-sectional view of the solar cell of FIG. 4 after the next process step in which the original substrate is removed by a sequence of lapping and/or etching steps in which the substrate 101, the buffer layer 103, and the etch stop layer 104, are removed. The etchant is growth substrate dependent.

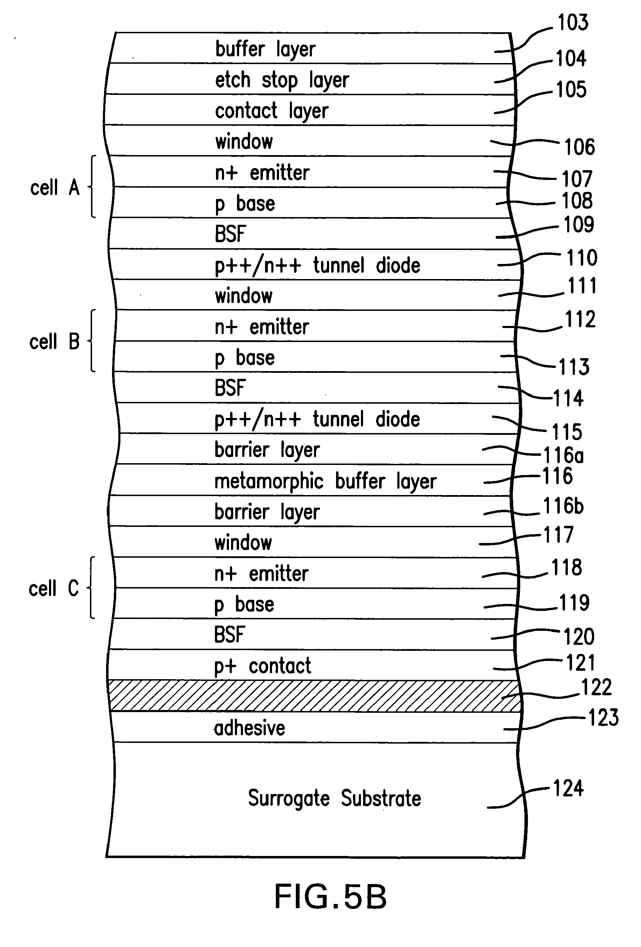

FIG. 5B is a cross-sectional view of the solar cell of FIG. 5A from the solar cell of FIG. 5A from the orientation with the surrogate substrate 124 being at the bottom of the Figure.

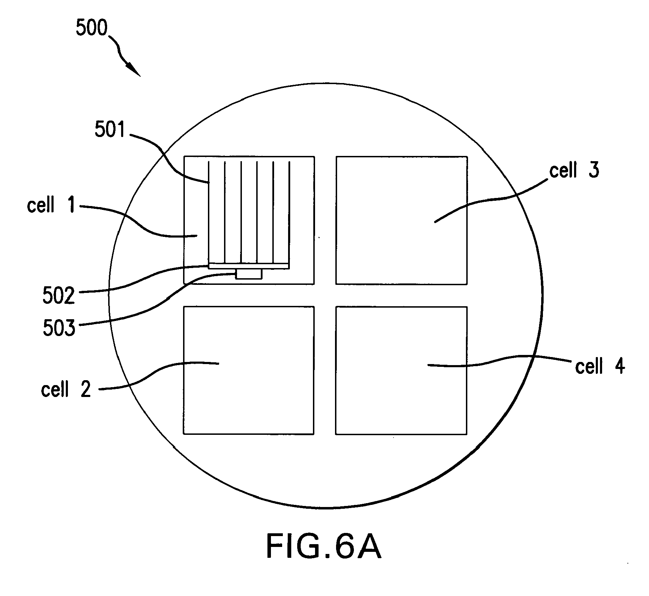

FIG. 6A is a top plan view of a wafer in which the solar cells are implemented.

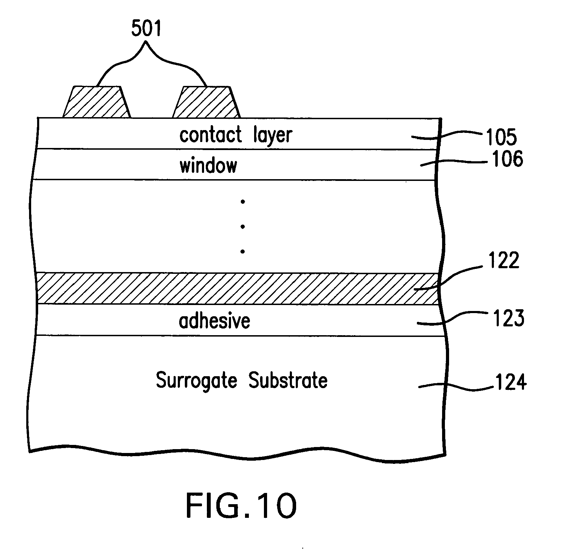

As more particularly illustrated in Cell 1, in each cell there are conductive grid lines 501 (more particularly shown in cross-section in FIG. 10) over the surface of the cell, an interconnecting bus line 502, and a contact pad 503 for making external electrical contact with the top of the cell.

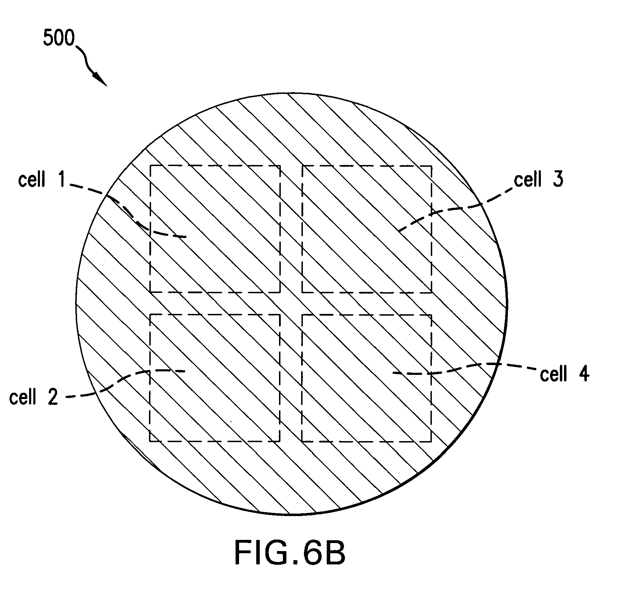

FIG. 6B is a bottom plan view of the wafer with four solar cells shown in FIG. 6A. In the embodiment depicted, the entire backside surface is covered with contact metal, representing layer 122

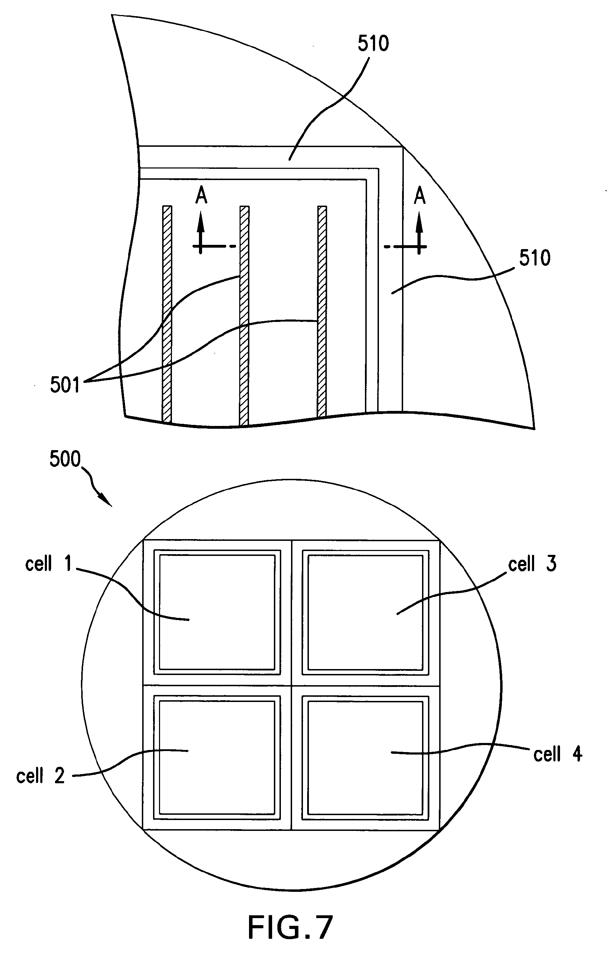

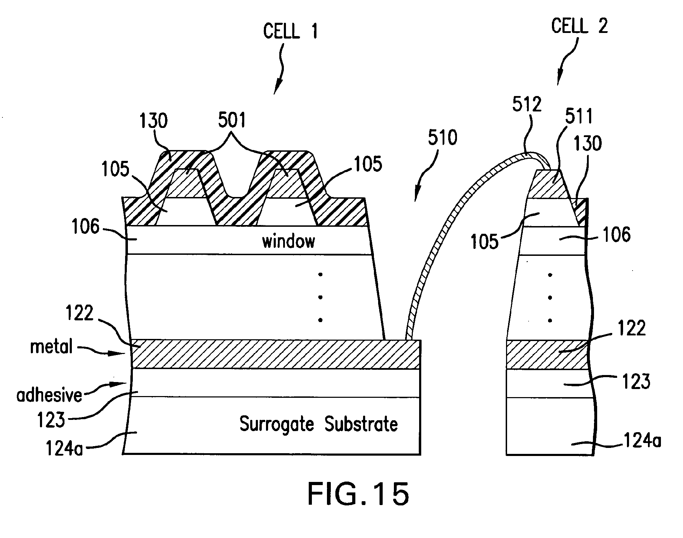

FIG. 7 is a top plan view of the wafer of FIG. 6A after the next process step in which a channel 510 is etched around the periphery of each cell using phosphide and arsenide etchants to isolate each cell and form a contact pad area electrically connected to the bottom contact layer. The use of such a pad area will be subsequently described in connection with FIG. 15.

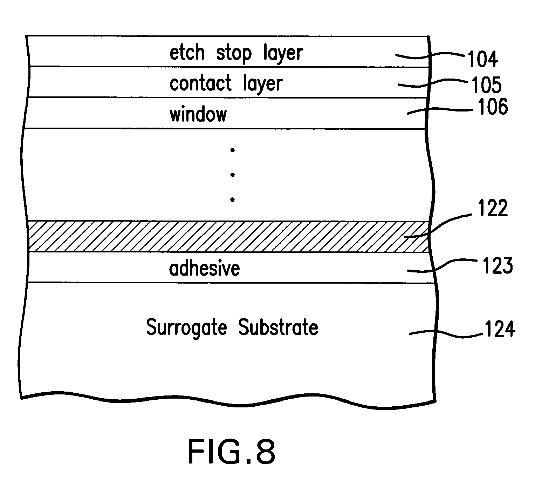

FIG. 8 is a simplified cross-sectional view of the solar cell of FIG. 5B depicting just a few of the top layers and lower layers over the surrogate substrate 124.

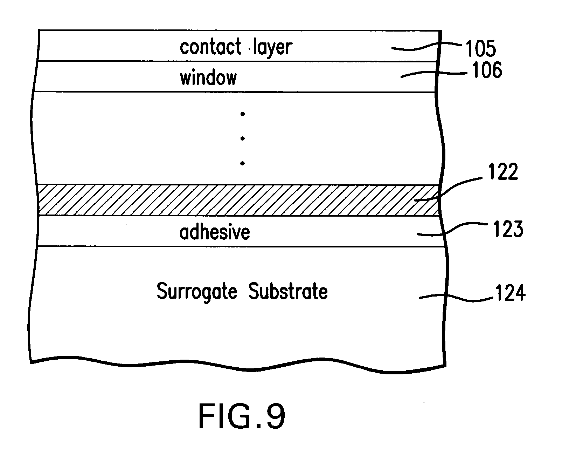

FIG. 9 is a cross-sectional view of the solar cell of FIG. 8 after the next process step in which the etch stop layer 104 is removed by a HCl/H₂O solution.

FIG. 10 is a cross-sectional view of the solar cell of FIG. 9 after the next sequence of process steps in which a photoresist mask (not shown) is placed over the contact layer 105 to form the grid lines 501. The grid lines 501 are deposited via evaporation and lithographically patterned and deposited over the contact layer 105. The mask is lifted off to form the metal grid lines 501.

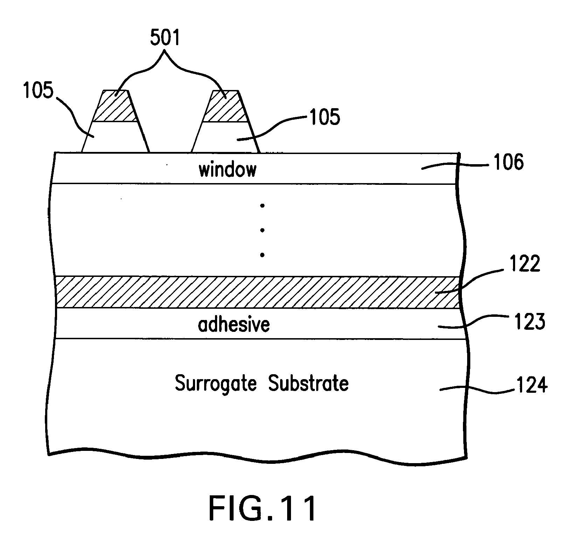

FIG. 11 is a cross-sectional view of the solar cell of FIG. 10 after the next process step in which the grid lines are used as a mask to etch down the surface to the window layer 106 using a citric acid/peroxide etching mixture.

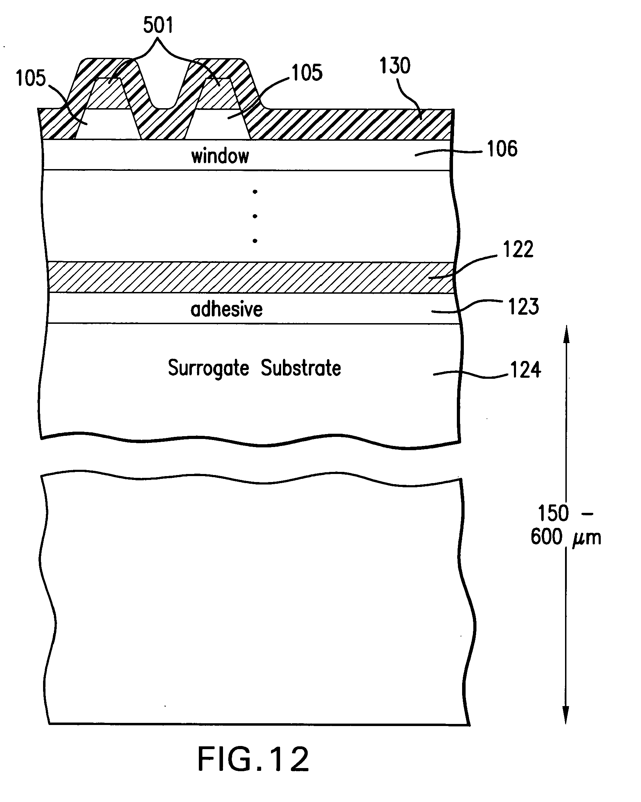

FIG. 12 is a cross-sectional view of the solar cell of FIG. 11 after the next process step in which an antireflective (ARC) dielectric coating layer 130 is applied over the entire surface of the "top" (sunward) side of the wafer with the grid lines 501.

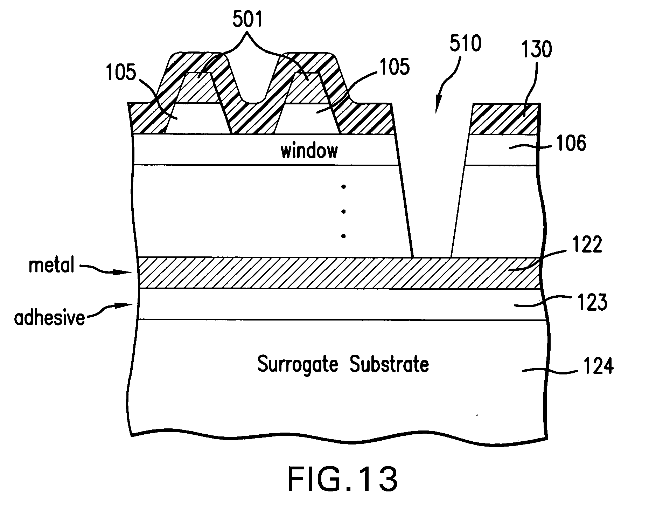

FIG. 13 is a cross-sectional view of the solar cell of FIG. 12 after the next process step according to the present invention in which a channel 510 or portion of the semiconductor structure is etched down to the metal layer 122 using phosphide and arsenide etchants leaving a mesa structure which constitutes the solar cell. The cross-section depicted in FIG. 13 is that as seen from the A-A plane shown in FIG. 7.

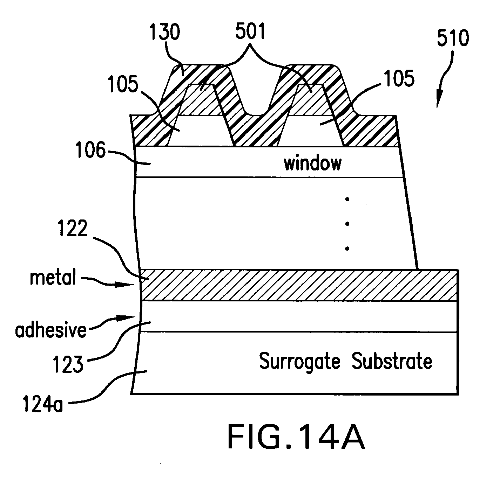

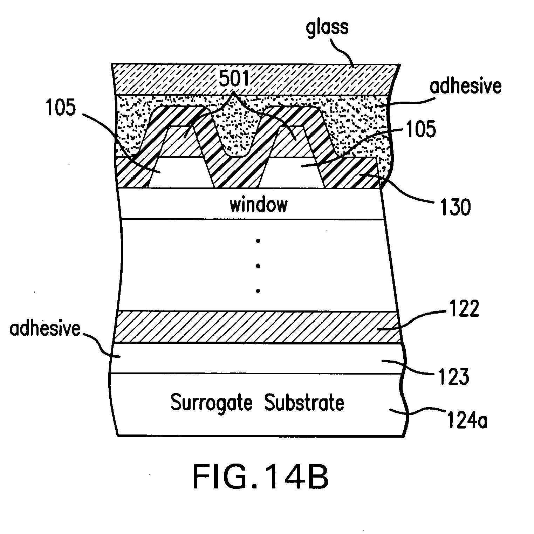

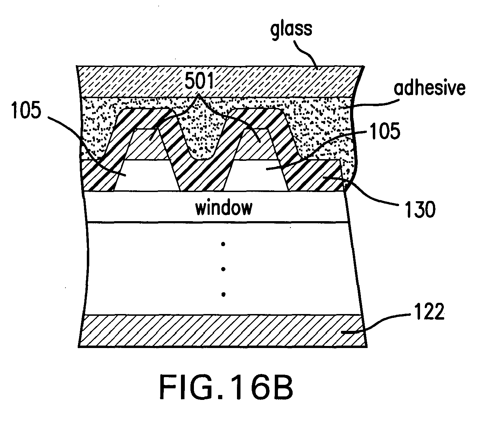

The next Figures will depict various embodiments of the invention of a thin inverted metamorphic solar cell on a rigid support, including (i) a thin cell mounted on a thinned substrate (Fig. 14A), (ii) a thin cell mounted on a thinned substrate with a coverglass (FIG. 14B), and (iii) a thin cell mounted on a coverglass (FIG. 16B).

FIG. 14A is a cross-sectional view of the solar cell of FIG. 13 after the next process step according to the present invention after the surrogate substrate 124 is thinned by a process of grinding, lapping or etching to a preferred thickness of about 2-6 mils. The right hand portion of the solar cell is then routed or cut to size, leaving the exposed metal layer 122 over the thinned substrate 124a which may be utilized to form a contact pad to the backside of the solar cell. In a first embodiment of the present invention, such as solar cells for use in terrestrial applications, the final structure of the solar cell is complete as depicted. In a variant of this first embodiment, the adhesive 123 and surrogate substrate 124a are conductive, so the bottom metal contact 122 is electrically coupled to the substrate 124a which then serves as the electrical contact to the backside of the solar cell. In such a variant, use of the layer 122 as a contact pad is unnecessary.

FIG. 14B is a cross-sectional view of the solar cell of FIG. 14A after the next process step according to a second embodiment in which a coverglass is added to the present invention. An adhesive is applied over the ARC layer 130 and a coverglass attached to the adhesive. Such an embodiment of a thin solar cell mounted on a thinned substrate with a coverglass is typically used for solar cells intended for space applications, or other harsh environments. Contact may be made either to layer 122, or in another variant, the adhesive 123 and surrogate substrate 124a are conductive, so the bottom metal contact 122 is electrically coupled to the substrate 124a which serves as the electrical contact to the solar cell.

FIG. 15 depicts the coupling of two adjacent solar cells Cell 1 and Cell 2 utilizing the metal layer 122 as a contact pad. The channel 510 in Cell 1 exposes a portion of the metal contact layer 122. A wire 512 is then welded or wire bonded between layer 122 on Cell 1 and the electrical contact pad 511 on Cell 2. Contact pad 511 makes electrical contact with the contact layer 105 of Cell 2 and thereby electrically couples to Cell 2. Such an electrical arrangement allows the cells to be connected in series.

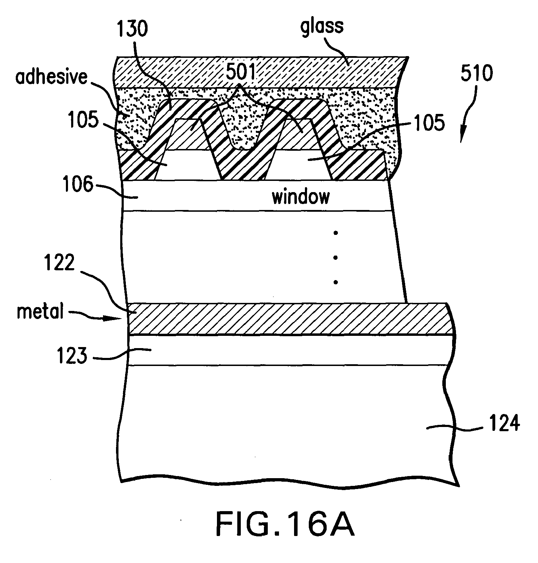

FIG. 16A is a cross-sectional view of the solar cell of FIG. 13 after the next process step according to a third embodiment of the present invention in which an adhesive is applied over the ARC layer 130 and a coverglass attached thereto.

FIG. 16B is a cross-sectional view of the solar cell of FIG. 14A after the next process step according to the third embodiment of the present invention in which the surrogate substrate 124 is entirely removed by grinding, lapping, or etching, resulting in the finished device structure of a thin metamorphic solar cell mounted on a rigid coverglass.

It will be understood that each of the elements described above, or two or more together, also may find a useful application in other types of constructions differing from the types of constructions differing from the types described above.

Although the preferred embodiment of the present invention utilizes a vertical stack of subcells with top and bottom electrical contacts, the subcells may alternatively be contacted by means of metal contacts to laterally conductive semiconductor layers between the subcells. Such arrangements may be used to form 3-terminal, 4-terminal, and in general, n-terminal devices. The subcells can be interconnected in circuits using these additional terminals such that most of the available photogenerated current density in each subcell can be used effectively, leading to high efficiency for the multijunction cell, notwithstanding that the photogenerated current densities are typically different in the various subcells.

As noted above, the present invention may utilize one or more homojunction cells or subcells, i.e., a cell or subcell in which the p-n junction is formed between a p-type semiconductor and an n-type semiconductor both of which have the same chemical composition and the same band gap, differing only in the dopant species and types. Subcell A, with p-type and n-type InGaP is one example of a homojunction subcell. Alternatively, the present invention may utilize one or more heterojunction cells or subcells, i.e., a cell or subcell in which the p-n junction is formed between a p-type semiconductor and an n-type semiconductor having different chemical compositions of the semiconductor material in the n-type and n-type regions, and/or different band gap energies in the p-type regions, in addition to utilizing different dopant species and type in the p-type and n-type regions that form the p-n junction.

The composition of the window or BSF layers may utilize other semiconductor compounds, subject to lattice constant and bandgap requirements, and may include AlInP, AlAs, AlP, AlGaInP, AlGaAsP, AlGaInAs, AlGaInPAs, GaInP, GaInAs, GaInPAs, AlGaAs, AlInAs, AlInPAs, GaAsSb, AlAsSb, GaAlAsSb, AlInSb, GaInSb, AlGaInSb, AIN, GaN, InN, GaInN, AlGaInN, GaInNAs, AlGaInNAs, ZnSSe, CdSSe, and similar materials, and still fall within the spirit of the present invention.

## Claims

1. A method of manufacturing a solar cell comprising:
providing a first substrate;
depositing on a first substrate a sequence of layers of semiconductor material forming a solar cell;
mounting a surrogate substrate on top of the sequence of layers;
removing the first substrate; and
thinning the surrogate substrate to a predetermined thickness.

2. A method as defined in claim 1, wherein the sequence of layers of semiconductor material forms a triple junction solar cell, including first, second and third solar subcells.

3. A method as defined in claim 1, wherein the mounting step includes adhering the solar cell to the surrogate substrate.

4. A method as defined in claim 3, wherein the surrogate substrate is a sapphire wafer.

5. A method as defined in claim 3, wherein the thinning of said surrogate substrate is done by grinding, lapping, or etching.

6. A method as defined in claim 5, further comprising depositing a metal contact layer over said sequence of semiconductor layers, and mounting said surrogate substrate on top of said metal contact layer.

7. A method as defined in claim 6, further comprising etching an opening through said layers of semiconductor material to the top of said metal contact layer.

8. A method as defined in claim 7, further comprising welding an electrical conductor to said metal contact layer to form an electrical contact to said solar cell.

9. A method as defined in claim 8, wherein said electrical conductor makes an electrical connection to an adjacent solar cell.

10. A method as defined in claim 3, wherein said surrogate substrate is electrically conductive and said substrate forms an electrical contact to said solar cell.

11. A method as defined in claim 1, further comprising attaching said solar cell to a glass supporting member.

12. A method as defined in claim 1, wherein said step of depositing a sequence of layers of semiconductor material includes forming a first solar subcell on said substrate having a first band gap; forming a second solar subcell over said first subcell having a second band gap smaller than said first band gap; forming a grading interlayer over said second subcell having a third band gap larger than said second band gap; forming a third solar subcell having a fourth band gap smaller than said second band gap such that said third subcell is lattice mis-matched with respect to said second subcell.

13. A method of manufacturing a solar cell as defined in claim 1, wherein said first substrate is composed of GaAs.

14. A method of manufacturing a solar cell as defined in claim 2, wherein said first solar subcell is composed of an InGa(Al)P emitter region and an InGa(Al)P base region.

15. A method as defined in claim 2, wherein said second solar subcell is composed of an InGaP emitter region and a GaAs base region.

16. A method as defined in claim 2, wherein said third solar subcell is composed of InGaAs.

17. A method as defined in claim 1, further comprising:
mounting the solar cell on rigid coverglass.

18. A method as defined in claim 1, wherein the thinning of said surrogate substrate removes the entire surrogate substrate.

19. A multijunction solar cell comprising:
a first solar subcell having a first band gap;
a second solar subcell disposed over said first subcell and having a second band gap smaller than said first band gap:
a grading interlayer disposed over said second subcell and having a third band gap greater than said second band gap;
a third solar subcell disposed over said interlayer that is lattice mis-matched with respect to said middle subcell and having a fourth band gap smaller than said second band gap; and
a rigid coverglass supporting said first, second and third solar subcells.

20. A multijunction solar cell as defined in claim 28, wherein the first solar subcell is the top cell and is composed of InGa(Al)P.

21. A multijunction solar cell as defined in claim 19, wherein the second solar subcell is composed of InGaP and In_{0.015}GaAs.

22. A multijunction solar cell as defined in claim 19, wherein the grading interlayer is composed of InGaAIAs.

23. A multijunction solar cell as defined in claim 19, wherein the third solar subcell is composed of In_{0.30}GaAs.

24. A multijunction solar cell as defined in claim 19, wherein the grading interlayer is composed of InₓGa₁₋ₓAlAs with x such that the band gap remains constant at 1.50 eV.
